# EUROPEAN PATENT APPLICATION

(11) **EP 4 220 703 A1**
(43) Date of publication of application: **02.08.2023**
(21) Application number: 21872386.4
(22) Date of filing: 17.09.2021
(51) Int. Cl.: H01L 23/00, H01L 23/36

(54) **SEMICONDUCTOR PACKAGE, ELECTRONIC EQUIPMENT, AND MANUFACTURING METHOD OF ELECTRONIC EQUIPMENT**

(30) Priority: 24.09.2020 JP 2020159895
(71) Applicant: Sony Interactive Entertainment Inc., Tokyo 108-0075 (JP)
(72) Inventor: SUGAWARA, Nobuyuki, Tokyo 108-0075 (JP); KAMBAYASHI, Asuka, Tokyo 108-0075 (JP); SUZUKI, Ryo, Tokyo 108-0075 (JP)
(74) Representative: Müller Hoffmann & Partner
(86) International application number: PCT/JP2021/034411
(87) International publication number: WO 2022/065257

(57) **Abstract**

Information regarding a semiconductor package (10) is written on a stiffener (14) and not on an upper surface (11a) of a semiconductor chip (11). The stiffener (14) is positioned outside an outer edge (11d) of the semiconductor chip (11) and inside an outer edge (17d) of a package base material (17). Further, a thermally conductive material (31) having fluidity is disposed between the upper surface (11a) of the semiconductor chip (11) and a radiator (50). Therefore, the semiconductor chip provides high cooling performance.

## Description

### [Technical Field]

The present invention relates to a semiconductor package, an electronic device, and an electronic device manufacturing method.

### [Background Art]

A semiconductor chip functioning, for example, as a central processing unit (CPU) or a graphics processing unit (GPU) is thermally connected to a radiator such as a heat sink or a heat pipe for cooling purposes. An existing electronic device uses grease as a thermally conductive material disposed between the semiconductor chip and the radiator (PTL 1). Further, as the thermally conductive material between the semiconductor chip and the radiator, electronic devices described in PTL 2 and PTL 3 use, instead of the grease, a fluid metal or another material that changes its fluidity and liquefies during an electronic device operation.

### [Citation List]

### [Patent Literature]

[PTL 1]
   Japanese Patent Laid-open No. 2012-69902
[PTL 2]
   Japanese Patent Laid-open No. 2007-335742
[PTL 3]
   PCT Patent Publication No. WO 2020/162417

### [Summary]

### [Technical Problem]

It is preferable that a liquefied metal to be used as the thermally conductive material be spread evenly over a surface of the semiconductor chip. However, when information regarding the semiconductor chip, such as a model number or a unique number, is written on the surface of the semiconductor chip by lasering or inking, the surface of the semiconductor chip becomes non-flat or areas differing in wettability (contact angle) between the surfaces of the liquid metal and semiconductor chip are formed on the surface of the semiconductor chip. Therefore, the thermally conductive material does not spread evenly over the surface of the semiconductor chip. This makes it difficult to provide high cooling performance.

### [Solution to Problem]

An example of an electronic device proposed by the present disclosure includes a semiconductor package and a radiator. The semiconductor package includes a semiconductor chip, a package base material on which the semiconductor chip is mounted, and a section positioned outside an outer edge of the semiconductor chip and inside an outer edge of the package base material. A thermally conductive material having fluidity is disposed between a surface of the semiconductor chip and the radiator. Information regarding the semiconductor package is written on the above-mentioned section of the semiconductor package and not on the surface of the semiconductor chip. According to the above-described electronic device, the semiconductor chip provides high cooling performance by using the thermally conductive material having fluidity.

Another example of the electronic device proposed by the present disclosure includes a semiconductor package and a radiator. The semiconductor package includes a semiconductor chip, a package base material on which the semiconductor chip is mounted, a first section on which a thermally conductive material having fluidity is formed to transfer heat from the semiconductor chip to the radiator through the thermally conductive material, and a second section that differs from the first section. Information regarding the semiconductor package is written on the second section. According to the above-described electronic device, the semiconductor chip provides high cooling performance by using the thermally conductive material having fluidity.

Yet another example of the electronic device proposed by the present disclosure includes a semiconductor package and a radiator. The semiconductor package includes a semiconductor chip and a package base material on which the semiconductor chip is mounted. A thermally conductive material having fluidity is disposed between a surface of the semiconductor chip and the radiator. The surface of the semiconductor chip has a first area and a second area. The second area has a lower temperature than the first area while the semiconductor chip operates. Information regarding the semiconductor package is written in the second area of the semiconductor chip and not in the first area. According to the above-described electronic device, the semiconductor chip provides high cooling performance by using the thermally conductive material having fluidity.

Still another example of the electronic device proposed by the present disclosure includes a semiconductor package and a radiator. The semiconductor package includes a semiconductor chip and a package base material on which the semiconductor chip is mounted. A surface of the semiconductor chip has an area where information regarding the semiconductor package is written. A surface treatment layer covering the area is formed on the surface of the semiconductor chip. A thermally conductive material having fluidity is disposed between the surface treatment layer and the radiator. According to the above-described electronic device, the semiconductor chip provides high cooling performance by using the thermally conductive material having fluidity.

An example of a semiconductor package proposed by the present disclosure includes a semiconductor chip, a package base material on which the semiconductor chip is mounted, and a section positioned outside the outer edge of the semiconductor chip in plan view and inside the outer edge of the package base material. Information regarding the semiconductor package is written on the above-mentioned section of the semiconductor package and not on a surface of the semiconductor chip. According to the above-described semiconductor package, the semiconductor chip provides high cooling performance by using a thermally conductive material having fluidity.

Another example of the semiconductor package proposed by the present disclosure includes a semiconductor chip and a package base material on which the semiconductor chip is mounted. A surface of the semiconductor chip has a first area and a second area. The second area has a lower temperature than the first area while the semiconductor chip operates. Information regarding the semiconductor package is written in the second area of the semiconductor chip and not in the first area. According to the above-described semiconductor package, the semiconductor chip provides high cooling performance by using a thermally conductive material having fluidity.

An example of an electronic device manufacturing method proposed by the present disclosure includes a step of preparing a semiconductor package including a semiconductor chip, a package base material on which the semiconductor chip is mounted, and a section positioned outside an outer edge of the semiconductor chip and inside an outer edge of the package base material, a step of writing information regarding the semiconductor package on the above-mentioned section of the semiconductor package and not on a surface of the semiconductor chip, and a step of disposing a thermally conductive material having fluidity on the surface of the semiconductor chip. According to the above-described electronic device manufacturing method, the semiconductor chip provides high cooling performance by using the thermally conductive material having fluidity.

Another example of the electronic device manufacturing method proposed by the present disclosure includes a step of preparing a semiconductor package including a semiconductor chip and a package base material on which the semiconductor chip is mounted, the semiconductor chip having a surface containing a first area and a second area that has a lower temperature than the first area while the semiconductor chip operates, a step of writing information regarding the semiconductor package in the second area of the semiconductor chip and not in the first area, and a step of disposing a thermally conductive material having fluidity on the surface of the semiconductor chip. According to the above-described electronic device manufacturing method, the semiconductor chip provides high cooling performance by using the thermally conductive material having fluidity.

Yet another example of the electronic device manufacturing method proposed by the present disclosure includes a step of preparing a semiconductor package including a semiconductor chip and a package base material on which the semiconductor chip is mounted, the semiconductor chip having a surface containing an area where information regarding the semiconductor package is written, a step of forming a surface treatment layer covering the area on the surface of the semiconductor chip, and a step of disposing a thermally conductive material having fluidity on the surface treatment layer. According to the above-described electronic device manufacturing method, the semiconductor chip provides high cooling performance by using the thermally conductive material having fluidity.

### [Brief Description of Drawings]

[FIG. 1]

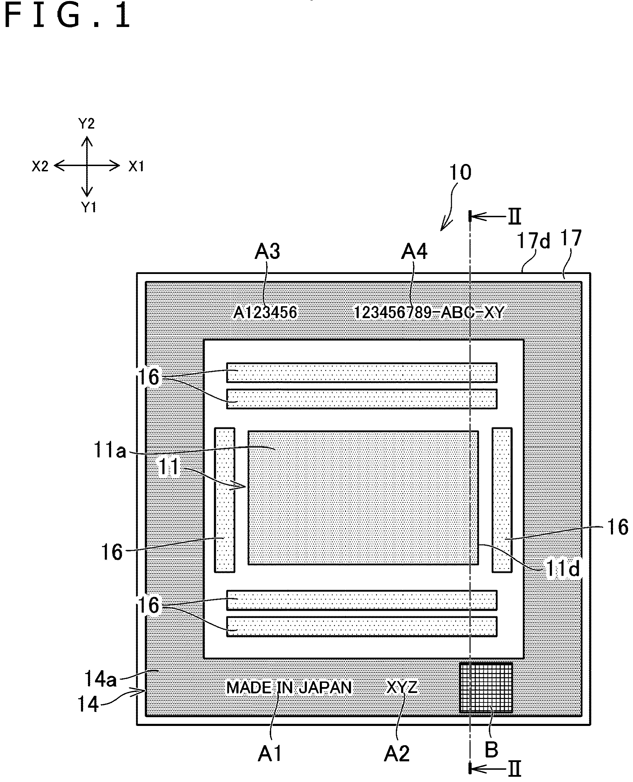

   FIG. 1 is a plan view illustrating an example of a semiconductor package proposed by the present disclosure.
[FIG. 2]

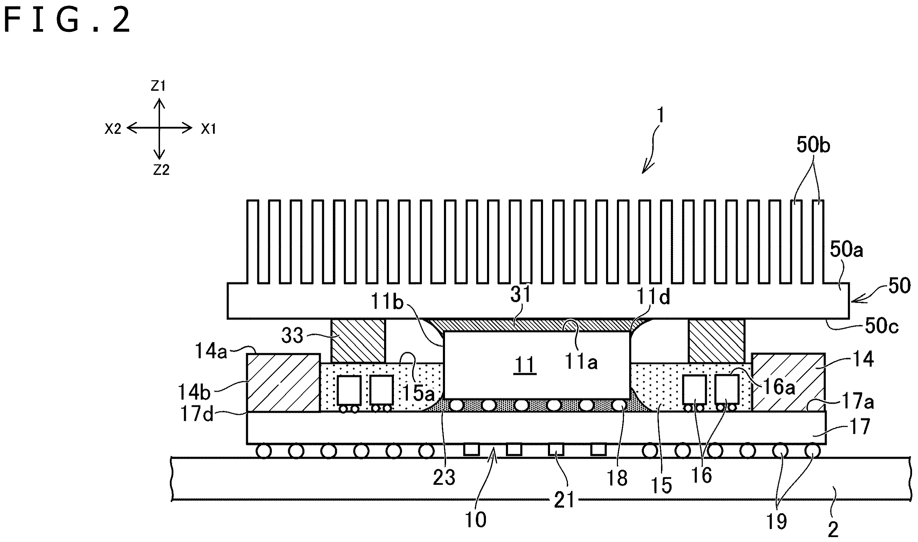

   FIG. 2 is a cross-sectional view of an electronic device including the semiconductor package taken along line II-II in FIG. 1.
[FIG. 3]

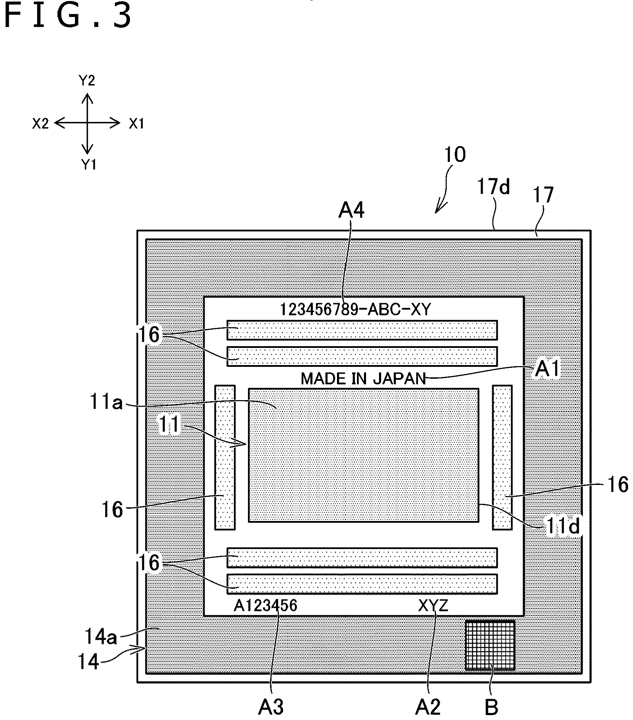

   FIG. 3 is a plan view illustrating another example of the semiconductor package proposed by the present disclosure.
[FIG. 4]

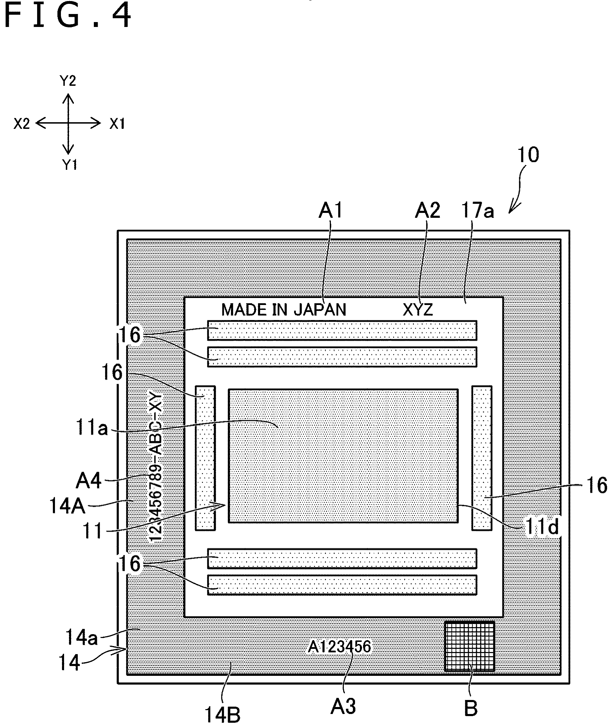

   FIG. 4 is a plan view illustrating yet another example of the semiconductor package proposed by the present disclosure.
[FIG. 5]

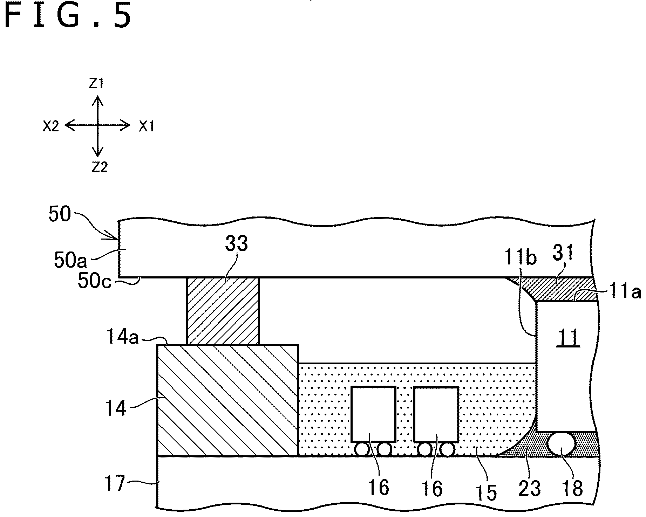

   FIG. 5 is a cross-sectional view illustrating a modification of the electronic device.
[FIG. 6]

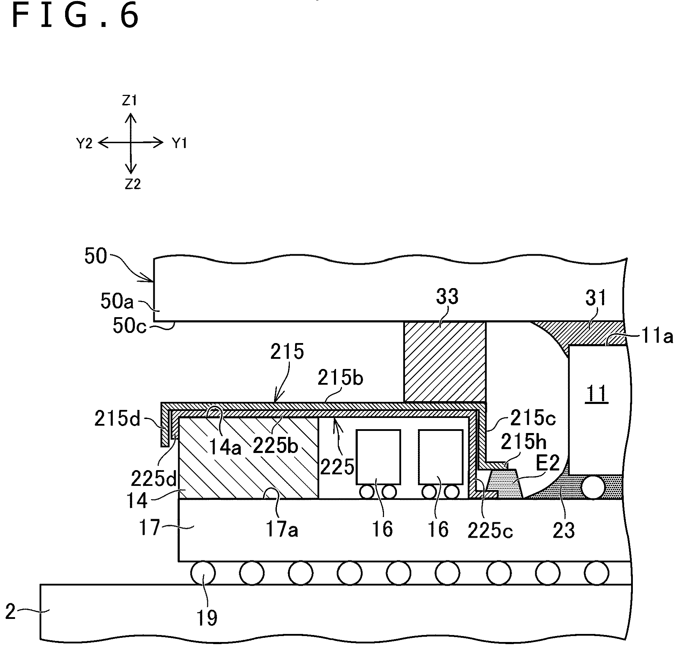

   FIG. 6 is a cross-sectional view illustrating another modification of the electronic device.
[FIG. 7]

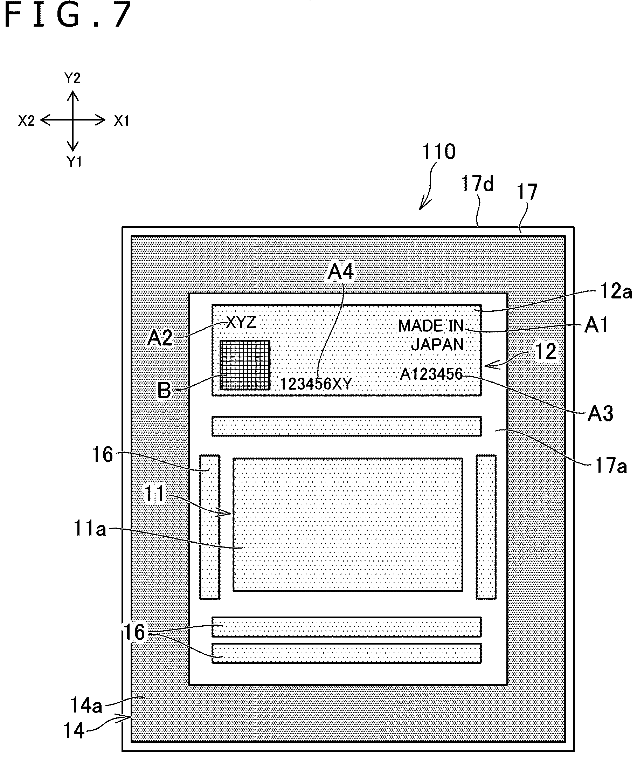

   FIG. 7 is a plan view illustrating still another example of the semiconductor package proposed by the present disclosure.
[FIG. 8]

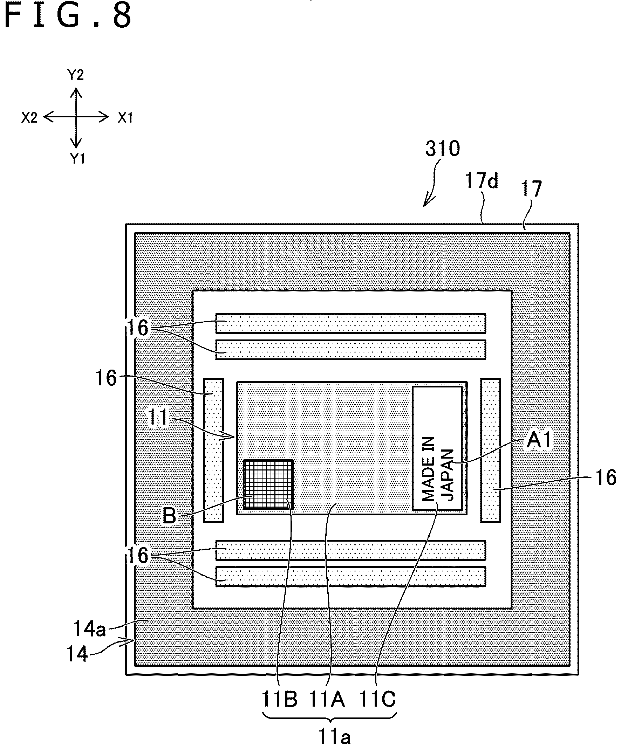

   FIG. 8 is a plan view illustrating an additional example of the semiconductor package proposed by the present disclosure.
[FIG. 9]

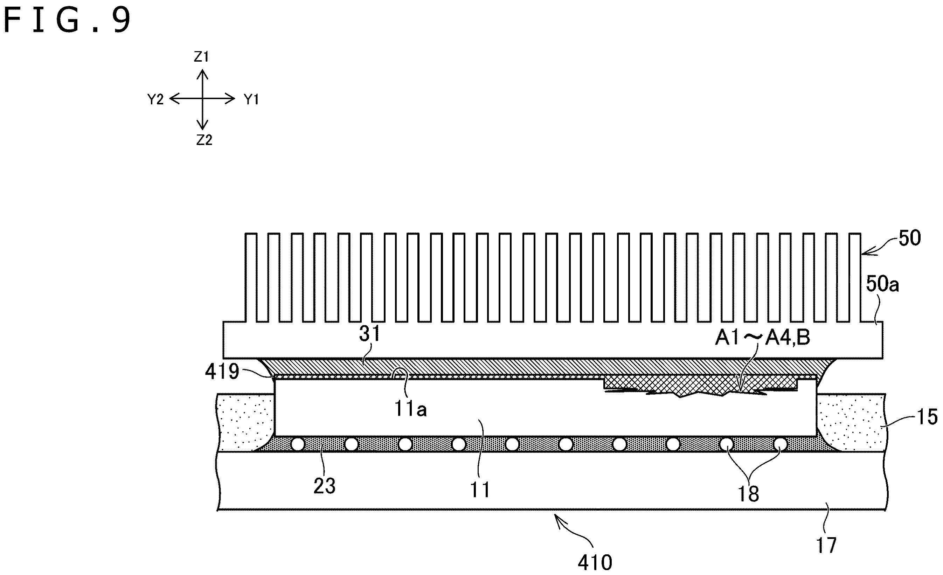

   FIG. 9 is a cross-sectional view illustrating a yet additional example of the semiconductor package proposed by the present disclosure.
[FIG. 10]

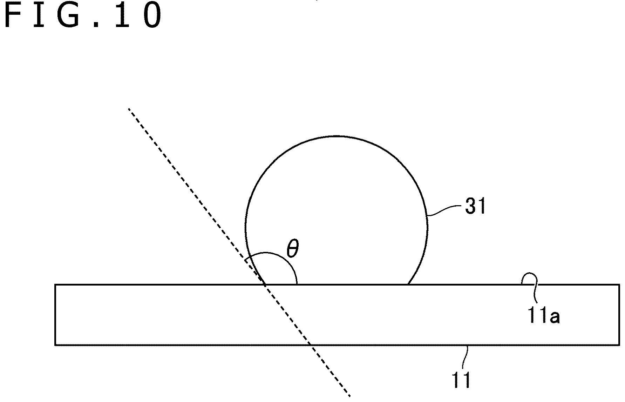

   FIG. 10 is a diagram illustrating a contact angle of a thermally conductive material having fluidity.

### [Description of Embodiment]

The following describes an electronic device and a semiconductor package that are proposed by the present disclosure. The specification describes an electronic device 1 and a semiconductor package 10 as the electronic device and semiconductor package proposed by the present disclosure. The electronic device proposed by the present disclosure may be applied, for example, to a video game console, a development machine for executing various programs (e.g., game programs) under development, and an information processing apparatus (e.g., personal computers, server equipment, or transport vehicle control devices) different from video game consoles.

In the following description, X1 and X2 depicted in FIG. 1 indicate a rightward direction and a leftward direction, respectively, and Y1 and Y2 depicted in FIG. 1 indicate a forward direction and a backward direction, respectively. Further, Z1 and Z2 depicted in FIG. 2 indicate an upward direction and a downward direction, respectively. These directions are used to explain a relative positional relation between the elements (parts, members, and sections) of the electronic device 1 and not to identify a posture of the electronic device 1 during its use.

### [Basic Configuration]

As depicted in FIG. 2, the electronic device 1 includes the semiconductor package 10, a main substrate 2, and a radiator 50. The description given in the specification assumes that the main substrate 2 is disposed below the semiconductor package 10 and that the radiator 50 is disposed above the semiconductor package 10. The main substrate 2 is not only used for mounting the semiconductor package 10, but also used for mounting, for example, connectors connecting to a RAM (Random Access Memory) and an external storage device (e.g., a solid-state drive (SSD) and a hard disk drive (HDD)), and connectors connecting the electronic device 1 and an external device (e.g., a power connector and a high-definition multimedia interface (HDMI) (registered trademark) connector). The main substrate 2 is attached, for example, to a housing (not depicted) of the electronic device 1 with fasteners such as screws or bolts.

As depicted in FIG. 2, the semiconductor package 10 includes a semiconductor chip 11 and a package base material 17. The package base material 17 is disposed below the semiconductor chip 11. The semiconductor chip 11, which is a semiconductor die (e.g., a silicon die), functions, for example, as a CPU or a GPU. The semiconductor chip 11 is, for example, flip-chip mounted on the upper surface 17a of the package base material 17. More specifically, a plurality of solder bumps 18 formed on the lower surface of the semiconductor chip 11 are soldered to bumps (not depicted) formed on the package base material 17. An underfill 23 is filled into a gap between the lower surface of the semiconductor chip 11 and the package base material 17. The underfill 23 is formed, for example, by resin and hardened between the semiconductor chip 11 and the package base material 17. The surface of the semiconductor die is exposed from an upper surface 11a of the semiconductor chip 11. The semiconductor chip 11 may be mounted on the package base material 17 by using, for example, a wire bonding method or a tape bonding method.

In addition to the semiconductor chip 11, a plurality of electrical parts may be mounted on the upper surface 17a of the package base material 17. In the example depicted in FIG. 2, a plurality of capacitors 16 are mounted on the package base material 17. A later-described stiffener 14 is attached to an outer circumferential edge of the package base material 17. The capacitors 16 are entirely covered with a later-described insulation 15.

The stiffener 14 is a square frame formed by metal, and is attached to the outer circumferential edge of the package base material 17. The stiffener 14 may be made, for example, with aluminum or copper. The stiffener 14 may be attached to the package base material 17 with use of, for example, adhesive or solder. The stiffener 14 reduces the warpage of the package base material 17. The semiconductor chip 11 and the capacitors 16 are disposed inside the stiffener 14.

As depicted in FIG. 2, the package base material 17 is mounted on the main substrate 2 included in the electronic device 1. For example, a ball grid array (BGA) 19 is formed on the lower surface of the package base material 17. More specifically, a plurality of solder bumps arranged in a grid are formed on the lower surface of the package base material 17. The BGA 19 is soldered to a conductive pad formed on the main substrate 2. The method of mounting the package base material 17 on the main substrate 2 is not limited to the use of the BGA 19. Various other mounting methods may alternatively be used. For example, a PGA (Pin Grid Array) having a pin-shaped lead terminal or an LGA (Land Grid Array) having an array of electrodes may be used. In addition to the BGA 19, a plurality of electronic parts (e.g., a plurality of capacitors 21) may be mounted on the lower surface of the package base material 17.

The radiator 50 which is, for example, a heat sink, includes a heat-receiving section 50a and a fin 50b. The heat-receiving section 50a is shaped like a plate. The fin 50b is, for example, formed above the heat-receiving section 50a. A paper chamber including a thin pouch-shaped container and liquid (e.g., water) filled into the container may be used as the heat-receiving section 50a. As another example, the radiator 50 may include a heat pipe. The radiator 50 may be pressed toward the semiconductor chip 11 by an undepicted elastic member (e.g., a spring). Further, the electronic device 1 may include an undepicted cooling fan that forms an air flow toward the radiator 50.

### [Thermally conductive material]

As depicted in FIG. 2, a lower surface 50c of the radiator 50 faces the upper surface 11a of the semiconductor chip 11. A thermally conductive material 31 is disposed between the lower surface 50c of the radiator 50 and the upper surface 11a of the semiconductor chip 11. The thermally conductive material 31 is in direct contact with the lower surface 50c of the radiator 50 and the upper surface 11a of the semiconductor chip 11. The radiator 50 and the semiconductor chip 11 are thermally connected with the thermally conductive material 31.

The thermally conductive material 31 is a material having fluidity. The thermally conductive material 31 may be in liquid or paste form. Further, the thermally conductive material 31 may be a material having an electrical conductivity, that is, a material having a high thermal conductivity.

The thermally conductive material 31 may be a material that is fluid no matter whether the semiconductor chip 11 is in an operating state or in a non-operating state. The semiconductor chip 11 is in the non-operating state while the electronic device is turned off. For example, when manufactured or transported, the electronic device is turned off. Meanwhile, the thermally conductive material 31 may be a material that becomes fluid upon receiving heat generated by the semiconductor chip 11 placed in the operating state and remains non-fluid while the semiconductor chip 11 is in the non-operating state (i.e., while the semiconductor chip 11 is at a normal temperature (e.g., 20°C)).

Using the above-described thermally conductive material 31 having fluidity improves the cooling performance of the semiconductor chip 11. Further, when the thermally conductive material 31 is fluid at a normal temperature, the radiator 50 can be separated from the semiconductor chip 11. As a result, when the electronic device 1 is to be repaired, it is easy to remove the radiator 50 from the semiconductor package 10 and make repairs.

For example, a liquid metal remaining liquid at a normal temperature may be used as the thermally conductive material 31. The liquid metal is usable, for example, when it contains one or more types of low-melting-point metal that are selected from among Ga (melting point: 29.8°C, thermal conductivity: 40.6 W/mk), In (melting point: 156.4°C, thermal conductivity: 81.6 W/mk), and Sn (melting point: 231.97°C, thermal conductivity: 66.6 W/mk) or when it is an alloy containing one or more types of the above-mentioned low-melting-point metal. Specific examples of the alloy are, for instance, In-Ag, SnAg-Cu, and In-Sn-Bi. Alternatively, an electrically conductive paste may be used as the thermally conductive material 31. A silver paste obtained by dispersing silver powder on resin may be used as the electrically conductive paste.

It is preferable that the upper surface 11a of the semiconductor chip 11 be entirely coated with the thermally conductive material 31. The thermally conductive material 31 may be in contact with a part of the lateral surface 11b of the semiconductor chip 11. An area where the lower surface 50c of the radiator 50 is coated with the thermally conductive material 31 may be larger than the semiconductor chip 11.

### [Information regarding Semiconductor Package and Writing of such Information]

Information regarding the semiconductor package 10 is written on the semiconductor package 10. The information regarding the semiconductor package 10 is, for example, one or more of a country of manufacture, a manufacturing company, a model number (or product name), and a unique number of the semiconductor package 10. The unique number of the semiconductor package 10 is the information for identifying each of a plurality of semiconductor packages 10 derived from a manufacturing line. The information regarding the semiconductor package 10 may include information regarding the semiconductor chip 11, which is a major part of the semiconductor package 10. The information regarding the semiconductor chip 11 is one or more of the country of manufacture, the manufacturing company, the model number (or product name), and the unique number of the semiconductor chip 11. The unique number of the semiconductor chip 11 is the information for identifying each of a plurality of semiconductor chips 11 derived from the manufacturing line.

One or more of a letter, a symbol, and a code indicating the above items of information are written on the semiconductor package 10 by at least one of inking, lasering, sealing, and engraving. More specifically, one or more of the letter, the symbol, and the code indicating the above information are written by reducing the flatness of the upper surface 11a of the semiconductor chip 11 or by creating a wettability difference between the thermally conductive material 31 having fluidity and the upper surface 11a.

The above items of information are usable, for example, for repairing the electronic device 1. In a case, for example, where a defect recognized in the electronic device 1 is found to be caused by the semiconductor chip 11, a quick action can be taken to correct the defect by using the model number or unique number of the semiconductor chip 11 as a clue. Here, it should be noted that the term "code" denotes, for example, a barcode or a two-dimensional code. For example, at least one of the model number and the unique number of the semiconductor chip 11 is coded and written on the semiconductor package 10. At the time of repair of the electronic device 1, the code is read by a code reader using, for example, infrared rays in order to identify, for example, the model number and the unique number of the semiconductor chip 11.

In the past, the above items of information regarding the semiconductor package 10 have been written on the upper surface 11a of the semiconductor chip 11. However, when the above items of information are written on the upper surface 11a of the semiconductor chip 11 by inking, lasering, sealing, or engraving, the flatness of the upper surface 11a of the semiconductor chip 11 decreases as mentioned above, and some sections of the upper surface 11a of the semiconductor chip 11 become different from each other in wettability between the thermally conductive material 31 having fluidity and the upper surface 11a. (The "wettability" is expressed as a contact angle θ (FIG. 10) that is formed by the surface tension of the thermally conductive material 31 when the thermally conductive material 31 having fluidity is disposed on the upper surface 11a of the semiconductor chip 11.) For example, in a case where the above items of information are written by lasering, sections on which the letter, the symbol, and the code are written are shaved off. This causes a change in surface roughness. As a result, some sections become different from each other in wettability with respect to the thermally conductive material 31 having fluidity. Meanwhile, in a case where the above items of information are written by inking, sections on which the letter, the symbol, and the code are swelled by ink, and sections made with different materials are formed on the upper surface 11a of the semiconductor chip 11. As a result, some sections become different from each other in wettability between the thermally conductive material 31 having fluidity and the upper surface 11a. Further, in a case where the above items of information are written by sealing (by attaching a seal), a sealed section is swelled, and sections made with different materials exist on the upper surface 11a of the semiconductor chip 11. As a result, some sections become different from each other in wettability between the thermally conductive material 31 having fluidity and the upper surface 11a. When this reduces the flatness of the upper surface 11a of the semiconductor chip 11 or makes some sections different from each other in wettability between the thermally conductive material 31 having fluidity and the upper surface 11a, the above-mentioned thermally conductive material 31 does not spread evenly over the upper surface 11a of the semiconductor chip 11. This causes a problem where, for example, the thermally conductive material 31 is not disposed on a section on which, for instance, letters are written by lasering or a problem where the thermally conductive material 31 is disposed intensively on a section on which, for instance, letters are written by inking or sealing.

As depicted in FIG. 10, the thermally conductive material 31 to be used may be a material that creates, for example, a contact angle θ (the wettability of the thermally conductive material 31) of greater than 90° between the upper surface 11a of the semiconductor chip 11 and the thermally conductive material 31 when the thermally conductive material 31 is disposed on the upper surface 11a. When the above-mentioned material is used, the above-mentioned problem is likely to occur. A typical example of the above-mentioned material is a liquid metal. More specifically, when a liquid metal which is liquid at a normal temperature is used as the thermally conductive material 31, the surface tension of the thermally conductive material 31 acts during a process where the upper surface 11a of the semiconductor chip 11 is coated with the thermally conductive material 31. Therefore, the above-mentioned problem becomes particularly conspicuous. The thermally conductive material 31 need not necessarily be made with a liquid metal.

Consequently, as depicted in FIG. 1, the information regarding the semiconductor package 10 is written on a section positioned outside an outer edge 11d of the semiconductor chip 11 and inside an outer edge 17d of the package base material 17 instead of being written on the upper surface 11a of the semiconductor chip 11, which is the major part of the semiconductor package 10. More specifically, one or more of a letter, a symbol, and a code indicating the information regarding the semiconductor package 10 are written on a section positioned outside the outer edge 11d of the semiconductor chip 11 and inside the outer edge 17d of the package base material 17 by at least one of inking, lasering, sealing, and engraving.

Stated differently, the semiconductor package 10 includes a first section (the upper surface 11a of the semiconductor chip 11) and a second section. The thermally conductive material 31 is disposed (coated) on the first section to transfer heat from the semiconductor chip 11 to the radiator 50 through the thermally conductive material 31. The second section, which is different from the first section, is not in direct contact with the radiator 50. The above-mentioned thermally conductive material 31 is not disposed on the second section. The information regarding the semiconductor package 10 is written on the second section. The above-described structure properly maintains the flatness of the upper surface 11a of the semiconductor chip 11, and does not allow any section to create a wettability (contact angle) difference from the thermally conductive material 31, which is liquid during a device operation. Therefore, the thermally conductive material 31 spreads evenly over the upper surface 11a of the semiconductor chip 11. Letters, symbols, logos, marks, and codes are not written on the upper surface 11a of the semiconductor chip 11. That is, no information (letters, symbols, logos, marks, or codes) regarding the semiconductor package 10 is written on the upper surface 11a. It should be noted that the means of writing the information regarding the semiconductor package 10, such as letters, is not limited to inking and other means mentioned above. Any other means may be used to write the information regarding the semiconductor package 10.

The above description assumes that the "first section" is, for example, the upper surface 11a of the semiconductor chip 11. In a case where a plurality of semiconductor chips are mounted on the package substrate 17, the "first section" may be a surface (upper surface) of a semiconductor chip that generates the greatest amount of heat (refer to the example depicted in FIG. 7). In the above-described structures, the above-mentioned "second section" is a section different from the first section, that is, a section different from the upper surface 11a of the semiconductor chip 11. In another example where a high-temperature area and a low-temperature area are formed on the upper surface of a semiconductor chip and the low-temperature area has a lower temperature than the high-temperature area during a semiconductor chip operation, the "first section" may be the high-temperature area and the "second section" may be the low-temperature area. In any of the above-described structures, the second section is not in direct contact with the radiator 50 as mentioned earlier. Further, the thermally conductive material 31 is not disposed on the second section. It is preferable that, when scattered, the thermally conductive material 31 remain unattached to the second section.

In the example depicted in FIG. 1, the section on which the information regarding the semiconductor package 10 is written is, for example, the surface of a part mounted on the package base material 17, that is, the surface of a component of the semiconductor package 10. More specifically, the information regarding the semiconductor package 10 is written on the surface (or more specifically, an upper surface 14a) of the stiffener 14 attached to the package base material 17. Using the stiffener 14 in this manner suppresses an increase in the number of parts. Further, writing the above items of information on the upper surface 14a of the stiffener 14 ensures the visibility of the above items of information.

In the example depicted in FIG. 1, the information regarding the semiconductor package 10 includes a letter image A1, a letter image A2, a letter image A3, a letter image A4, and a code B. The letter image A1 indicates the country of manufacture of the semiconductor chip 11. The letter image A2 indicates the manufacturing company of the semiconductor chip 11. The letter image A3 indicates the model number of the semiconductor chip 11. The letter image A4 indicates the unique number of the semiconductor chip 11. The code B contains the above items of information. (The "letter images" in the specification include, for example, letters, symbols, marks, and logos.) The information contained in the code B may be some of the items of information indicated by letter images A1 to A4. The code B preferably contains the unique number of the semiconductor chip 11.

The manufacturing process of the semiconductor package 10 can be simplified by adopting the structure depicted in FIG. 1, which is designed to write all the required items of information on one surface (upper surface 14a) of one member (stiffener 14) as described above.

Moreover, the code B and the letter images A1 to A4 may be written by the same means. For example, the code B and the letter images A1 to A4 may be all written by lasering or inking. This makes it possible to further simplify the manufacturing process of the semiconductor package 10.

It should be noted that the section on which the information regarding the semiconductor package 10 is written is not limited to the example depicted in FIG. 1. For example, the information regarding the semiconductor package 10 may be written on a lateral surface 14b (see FIG. 2) of the stiffener 14 or dispersedly written on the upper surface 14a and the lateral surface 14b.

Further, the part on which the information regarding the semiconductor package 10 is written is not limited to the stiffener 14. For example, the information regarding the semiconductor package 10 may be written on the surface of another electronic part mounted on the package base material 17, or a dedicated part on which the information regarding the semiconductor package 10 is written may be mounted on the package base material 17. In such a case, a description, a symbol, or a mark indicating that the letter images A1 to A4 and the code B represent the information regarding the semiconductor chip 11 may be written in addition to the letter images A1 to A4 and the code B. Furthermore, in a case where the information regarding the semiconductor package 10 is written on the surface of another electronic part mounted on the package base material 17, the information regarding the semiconductor package 10 and the information regarding the electronic part (model number and specific information) may be written on the electronic part.

The section on which the information regarding the semiconductor package 10 is written may be the upper surface 17a of the package base material 17 as illustrated in FIG 3. In the example depicted in FIG. 3, the letter images A1 to A4 are written on the upper surface 17a of the package base material 17, whereas the code B containing the items of information indicated by the letter images A1 to A4 is written on the upper surface 14a of the stiffener 14. In this case, the information indicated by the upper surface 17a of the package base material 17 and the information indicated by the upper surface 14a of the stiffener 14 may be written by different means. For example, the information indicated by the upper surface 17a of the package base material 17 may be written by inking, and the information indicated by the upper surface 14a of the stiffener 14 may be written by lasering. When such different means are used, it is possible to properly maintain a protective layer formed on the surface of the package base material 17.

Moreover, the information regarding the semiconductor package 10 may be dispersedly written on the upper surface 14a of the stiffener 14 and the upper surface 17a of the package base material 17 as depicted in FIG. 4. In the example of FIG. 4, letter image A4 indicating the specific information regarding the semiconductor chip 11 is written on a left extension of the stiffener 14, whereas the code B and letter image A3 indicating the model number are written on the upper surface of a front extension 14B of the stiffener 14. The extensions 14A and 14B are orthogonal to each other. The letter image A2 which indicates the manufacturing company and the letter image A1 which indicates the country of manufacture of the semiconductor chip 11 are recorded on the package base material 17.

### [Sealing Member and Insulation]

As depicted in FIG. 2, the semiconductor package 10 includes the capacitors 16 and the insulation 15. The capacitors 16 are formed on the package base material 17. The insulation 15 covers conductive elements such as circuit patterns. The insulation 15 is formed and filled between the inner lateral surface of the stiffener 14 and the lateral surface 11b of the semiconductor chip 11. The insulation 15 is, for example, resin. More specifically, the insulation 15 is liquid or a gel resin that is hardened. For example, an ultraviolet curable resin may be used as the insulation 15. The insulation 15 prevents the thermally conductive material 31 from coming into contact with the capacitors 16, the circuit patterns, and other conductive elements.

As depicted in FIG. 2, a height (the height from the upper surface 17a of the package substrate 17) of an upper surfaces 16a of the capacitors 16 is smaller than a height of the upper surface 11a of the semiconductor chip 11. It is preferable that the upper surfaces 16a of the capacitors 16 be covered with the insulation 15. A height of the upper surface 14a of the stiffener 14 (the height from the upper surface 17a of the package substrate 17) is such that the upper surface 14a of the stiffener 14 is exposed from an upper surface 15a of the insulation 15. As described later in detail, the semiconductor package 10 may include, instead of the insulation 15, a sheet for covering the upper surfaces 16a of the capacitors 16 (see FIG. 6).

As depicted in FIG. 2, the electronic device 1 includes a sealing member 33 that encloses the thermally conductive material 31 in plan view. The sealing member 33 is formed, for example, by a material having a cushioning property. More specifically, the sealing member 33 is formed, for example, by a material that permits the sealing member 33 to change its thickness in a direction in which the upper surface 11a of the semiconductor chip 11 faces the lower surface 50c of the radiator 50, that is, in a vertical direction. The sealing member 33 is made, for example, with rubber, a sponge, foamable resin, or silicone.

An opening is formed in the sealing member 33 in order to expose the upper surface 11a of the semiconductor chip 11, and the thermally conductive material 31 and the semiconductor chip 11 are positioned inside the sealing member 33. The sealing member 33 is separated outward from the outer edge (lateral surface 11b) of the semiconductor chip 11, and disposed between the semiconductor package 10 and the lower surface 50c of the radiator 50 in order to seal the gap between them. This limits the range over which the thermally conductive material 31 having fluidity scatters. Consequently, as described later, the thermally conductive material 31 is prevented from attaching to the letter images A1 to A4 and the code B. In the example depicted in FIG. 2, the sealing member 33 is disposed inside the stiffener 14.

### [Positional Relation between Sealing Member and Code, etc.]

The section on which the information regarding the semiconductor package 10 is written should preferably be positioned outside the sealing member 33. This prevents the thermally conductive material 31 from attaching to the section on which the information regarding the semiconductor package 10 is written (e.g., the section on which the code B and the letter images A1 to A4 are written) even in a case where the thermally conductive material 31, which is fluidized, scatters inside the sealing member 33. Therefore, for example, repair work can be efficiently performed.

In the example depicted in FIG. 1, the letter images A1 to A4 and the code B are formed on the surface of the stiffener 14. In FIG. 2, the sealing member 33 is positioned inside the stiffener 14. Therefore, the letter images A1 to A4 and the code B written on the surface of the stiffener 14 are positioned outside the sealing member 33. As a result, the thermally conductive material 31 can be effectively suppressed from attaching to the letter images A1 to A4 and the code B written on the surface of the stiffener 14.

In the example depicted in FIG. 3, the letter images A1 to A4 indicating the information regarding the semiconductor chip 11 are written on the surface of the package base material 17, whereas the code B is written on the stiffener 14. In the example depicted in FIG. 2, the insulation 15 is formed inside the stiffener 14. Therefore, in the semiconductor package 10 depicted in FIG. 3, the code B is positioned outside the sealing member 33. This effectively suppresses the thermally conductive material 31 from attaching to the code B. Meanwhile, the letter images A1 to A4 written on the package base material 17 are covered with the insulation 15. In a case where the insulation 15 is formed by a transparent material, repairers are able to read the letter images A1 to A4 through the insulation 15.

Further, in the example depicted in FIG. 4, letter images A3 and A4 respectively indicating the model number and specific information regarding the semiconductor chip 11 and the code B are written on the stiffener 14, whereas letter images A1 and A2 respectively indicating the country of manufacture and the manufacturing company are written on the surface (more specifically, on the upper surface 17a) of the package base material 17. In the semiconductor package 10 depicted in FIG. 4, the code B and letter images A3 and A4 are positioned outside the sealing member 33. This effectively suppresses the thermally conductive material 31 from attaching to the code B and the letter images A3 and A4. Meanwhile, the letter images A1 and A3 written on the package base material 17 are covered with the insulation 15.

The position of the sealing member 33 is not limited to the position depicted in the example of FIG. 2. For example, the insulation 15 may be formed only at the positions of the capacitors 16 to position the sealing member 33 inside the insulation 15 and surround the semiconductor chip 11. Further, the sealing member 33 may be vertically sandwiched between the upper surface 17a of the package substrate 17 and the lower surface 50c of the radiator 50. The semiconductor package 10 illustrated in FIGS. 1, 3, and 4 may be applied to the above-described structure. In this case, the code B depicted in FIGS. 1, 3, and 4 is positioned outside the sealing member 33. This prevents the thermally conductive material 31, which is fluidized, from attaching to the code B. Furthermore, the letter images written on the stiffener 14 (e.g., letter images A1 to A4 depicted in FIG. 1) are also positioned outside the sealing member 33. This prevents the thermally conductive material 31 from attaching to the letter images.

FIG. 5 is a cross-sectional view illustrating a modification of the electronic device 1. The sealing member 33 may be positioned on the stiffener 14 as illustrated in FIG. 5. In the example depicted in FIG. 5, the sealing member 33 is vertically sandwiched between the upper surface 14a of the stiffener 14 and the lower surface 50c of the radiator 50. The semiconductor package 10 illustrated in FIGS. 1, 3, and 4 may be applied to the above-described structure. In this case, the code B formed on the upper surface 14a of the stiffener 14 is positioned below the sealing member 33. More specifically, the code B is covered with the sealing member 33. This prevents the thermally conductive material 31 from attaching to the code B. Further, the letter images written on the stiffener 14 (e.g., letter images A1 to A4 depicted in FIG. 1) are also positioned below the sealing member 33. This prevents the thermally conductive material 31 from attaching to the letter images.

It should be noted that, in the structure depicted in FIG. 5, the sealing member 33 may be mounted on the lower surface 50c of the radiator 50. For example, the sealing member 33 may be glued to the lower surface 50c of the radiator 50. When the radiator 50 is removed from the semiconductor package 10 while the above-described configuration is adopted, the above-mentioned letter images and the code B written on the upper surface 14a of the stiffener 14 are automatically exposed. Therefore, repair work can be efficiently performed.

FIG. 6 is a cross-sectional view illustrating another modification of the electronic device 1. In the example of FIG. 6, the semiconductor package 10 includes insulating sheets 215 and 225. The insulating sheets 215 and 225, which are formed by an insulating material, are used as the insulation that covers the capacitors 16, the circuit patterns, and other conductive elements.

As depicted in FIG. 6, the insulating sheet 215 has an upper wall 215b and an inner wall 215c. The upper wall 215b is positioned above the capacitors 16. The inner wall 215c is positioned inside the capacitors 16 (positioned toward the semiconductor chip 11). The lower edge (attachment section 215h) of the inner wall 215c of the insulating sheet 215 is attached to the package base material 17. The insulating sheet 225 is disposed below the insulating sheet 215. The two insulating sheets 215 and 225 overlap with each other. (The insulating sheet 215 and the insulating sheet 225 are hereinafter respectively referred to as the upper sheet and the lower sheet.) The lower sheet 225 has an inner wall 225c that is also positioned inside the capacitors 16 (positioned toward the semiconductor chip 11). The lower edge of the inner wall 225c is attached to the package base material 17.

The upper sheet 215 may be made, for example, with an engineering plastic material such as polycarbonate or polyamide. The lower sheet 225 may be made with a material such as polyethylene terephthalate, and may have flexibility.

As depicted in FIG. 6, the sealing member 33 is vertically sandwiched between the upper sheet 215 and the lower surface 50c of the radiator 50. The sealing member 33 is disposed along the inner edge of the upper wall 215b of the upper sheet 215.

The upper sheet 215 and the lower sheet 225 have the upper wall 215b and an upper wall 225b, respectively. These upper walls 215b and 225b cover the capacitors 16 and the stiffener 14. The upper sheet 215 and the lower sheet 225 have outer walls 215d and 225d, respectively. The outer walls 215d and 225d hang from the outer edges of the upper walls 215b and 225b, respectively, so as to cover the stiffener 14. The outer walls 215d and 225d are not attached to the stiffener 14. Unlike the example of FIG. 6, the sealing member 33 may extend from the inner edge of the upper wall 215b to the upper side of the stiffener 14.

The semiconductor package 10 depicted in FIG. 1 may be applied to the structure depicted in FIG. 6. In such a case, the letter images A1 to A4 and the code B written on the upper surface 14a of the stiffener 14 are covered with the upper sheet 215 and the lower sheet 225. As a result, the thermally conductive material 31, which is fluidized can be suppressed from attaching to the letter images A1 to A4 and the code B. When repairing the electronic device 1, the repairers are able to properly read the code B with a code reader by peeling off the upper sheet 215 and the lower sheet 225.

Further, the semiconductor package 10 depicted in FIG. 3 may be applied to the structure depicted in FIG. 6. In that case, the code B written on the stiffener 14 is covered with the upper sheet 215 and the lower sheet 225. Additionally, the letter images A1 to A4 written on the package base material 17 are also covered with the upper sheet 215 and the lower sheet 225. Therefore, the thermally conductive material 31 which is fluidized can be suppressed from attaching to the letter images A1 to A4.

Furthermore, the semiconductor package 10 depicted in FIG. 4 may be applied to the structure depicted in FIG. 6. In that case, letter images A1 and A3 and the code B written on the upper surface 14a of the stiffener 14 are covered with the upper sheet 215 and the lower sheet 225. The letter images A2 and A4 written on the surface (more specifically, on the upper surface 17a) of the package base material 17 are also covered with the upper sheet 215 and the lower sheet 225.

It should be noted that, in the example of FIG. 6, the attachment section 215h is formed on the lower end of the inner wall 215c of the upper sheet 215. The attachment section 215h is mounted on the package base material 17 by using a liquid gasket E2. Meanwhile, the lower sheet 225 is mounted on the package base material 17 by using, for example, an adhesive tape (a tape whose surfaces are both coated with an adhesive) or an adhesive agent. The liquid gasket, which is fluid at a normal temperature, dries or becomes equalized in a fixed period of time after being coated on a joint surface, and forms an elastic or adhesive thin layer. The liquid gasket may be made, for example, with a phenolic material, a modified ester material, a silicone material, or an acrylic material. Using the above-described liquid gasket provides high sealing performance between the attachment section 215h of the insulating sheet 215 and the package base material 17.

Since the thermally conductive material 31 has fluidity, it may leak out from a gap between the lower surface 50c of the radiator 50 and the upper surface 11a of the semiconductor chip 11. After being leaked out, the thermally conductive material 31 attaches to the liquid gasket E2. When the radiator 50 and the upper sheet 215 are removed for repairing the electronic device or replacing defective parts, the liquid gasket E2 to which the thermally conductive material 31 is attached may scatter and spread around. In the structure depicted in FIG. 6, the lower sheet 225 is disposed below the upper sheet 215 to cover the capacitors 16. This prevents both the liquid gasket E2 and the thermally conductive material 31 from scattering toward the capacitors 16 and other conductive elements at the time of the removal of the radiator 50 and upper sheet 215.

It should be noted that, unlike the example of FIG. 6, only one sheet may be used to cover, for instance, the capacitors 16. For example, the stiffener 14 and the capacitors 16 may be covered with only the insulating sheet 215 or covered with only the insulating sheet 225.

The structures of the sheets 215 and 225 are not limited to those illustrated in the example of FIG. 6. For example, the sheets 215 and 225 may have an outer wall positioned between the stiffener 14 and the capacitors 16. That is, the sheets 215 and 225 do not need to cover the stiffener 14. In such a case, the sealing member 33 may be sandwiched between the upper surface 14a of the stiffener 14 and the lower surface 50c of the radiator 50 or may be disposed between the sheets 215 and 225 and the radiator 50.

An example of an electronic device manufacturing method, that is, the method of manufacturing the electronic device 1, will now be described.

First of all, the semiconductor package 10 is prepared. The semiconductor package 10 includes the semiconductor chip 11 and the package base material 17 on which the semiconductor chip 11 is to be mounted. As mentioned earlier, the capacitors 16 and other parts may be mounted on the package base material 17. Further, the stiffener 14 is mounted on the package base material 17, and the earlier-described insulation 15 is formed on the package base material 17. Instead of the insulation 15, the sheets 215 and 225 (FIG. 6) may be attached to the package base material 17. Next, the information regarding the semiconductor package 10 (e.g., the above-mentioned specific information regarding the semiconductor chip 11) is written on a section of the semiconductor chip 11 that is positioned outside the outer edge 11d of the semiconductor chip 11 and inside the outer edge 17d of the package base material 17 instead of being written on the upper surface 11a of the semiconductor chip 11. For example, as depicted in FIG. 1, the information regarding the semiconductor package 10 is written on the stiffener 14 by lasering, inking, or sealing. No letters, symbols, logos, marks, or codes are written on the upper surface 11a of the semiconductor chip 11.

The semiconductor package 10 is then mounted on the main substrate 2 by using the BGA 19. The thermally conductive material 31 having fluidity is disposed on the upper surface 11a of the semiconductor chip 11. In this instance, it is preferable that the thermally conductive material 31 be spread all over the upper surface 11a of the semiconductor chip 11. Further, the sealing member 33 which surrounds the semiconductor chip 11 is attached to the semiconductor package 10 or the radiator 50. Finally, the radiator 50 is disposed on the upper surface 11a of the semiconductor chip 11 and thermally connected to the semiconductor chip 11. It should be noted that, before the radiator 50 is disposed on the upper surface 11a of the semiconductor chip 11, the thermally conductive material 31 may also be coated on the lower surface 50c of the radiator 50. One example of the electronic device manufacturing method has been described above.

### [Example of Writing on Another Electronic Part]

FIG. 7 is a plan view illustrating a semiconductor package 110 as still another example of the semiconductor package. In FIG. 7, elements identical with those explained above are designated by the same reference numerals as the corresponding elements. The following mainly describes the difference from the semiconductor package described thus far. The examples described thus far may be applied to matters not covered by the description of the semiconductor package 110.

As electronic parts to be mounted on the package base material 17, the semiconductor package 110 may include not only the semiconductor chip 11, which functions as a CPU or a GPU (e.g., a silicon die), but also a part (the "second section" described in the appended claims) that generates a smaller amount of heat than the semiconductor chip 11 (the "first section" described in the appended claims) and has a lower temperature than the semiconductor chip 11 during an operation of the semiconductor package 10. One example of the above-mentioned part is an electronic part such as a semiconductor chip 12 that functions as a RAM (random access memory) or a flash memory. In this case, one or more of the letter images A1 to A4 indicating the information regarding the semiconductor package 10 and the code B containing such information may be written on a surface (upper surface 12a) of the semiconductor chip 12. These items of information may be written by inking, lasering, or sealing. In this instance, explanations, symbols, and marks indicating that the letter images A1 to A4 and the code B represent the information regarding the semiconductor chip 11 may be written in addition to the letter images A1 to A4 and the code B. Further, the information regarding the semiconductor chip 12, such as the manufacturing company, the model number (product name), and the unique number of the semiconductor chip 12, may be written on the upper surface 12a of the semiconductor chip 12. Furthermore, the semiconductor chip 12 may be configured such that the silicon die is sealed with resin. Moreover, the letter images A1 to A4 and the code B may be written on the surface of the resin.

The semiconductor chip 12 described above may be smaller than the semiconductor chip 11. The semiconductor chip 12 may be larger than half the size of the semiconductor chip 11. Unlike this, the semiconductor chip 12 may have a larger size than the semiconductor chip 11.

The whole information regarding the semiconductor chip 11 may be written on the semiconductor chip 12. In such a case, the semiconductor package 10 does not need to include the stiffener 14.

As another example, the semiconductor package 110 depicted in FIG. 7 may be configured such that the code B is written on the stiffener 14 while only letter images A1 to A4 are written on the semiconductor chip 12.

In the semiconductor package 110 depicted in FIG. 7, the semiconductor chip 12 may be covered with the insulation 15, which is insulative, as is the case with the capacitors 16 depicted in FIG. 2. As another example, the semiconductor chip 12 and the capacitors 16 may be covered with the insulating sheet 215 (or insulating sheet 225) depicted in FIG. 6. In such a case, the repairers of the electronic device 1 are able to properly read the code B with a code reader by peeling off the insulating sheets 215 and 225.

### [Example of Writing in Low-Temperature Areas]

FIG. 8 is a plan view illustrating a semiconductor package 310 as an additional example of the semiconductor package. In FIG. 8, elements identical with those explained above are designated by the same reference numerals as the corresponding elements. The following mainly describes the difference from the semiconductor package described thus far. The examples described thus far may be applied to matters not covered by the description of the semiconductor package 310.

In the semiconductor package 310, the semiconductor chip 11 has a high-temperature area 11A (the "first section" described in the appended claims) and low-temperature areas 11B and 11C (the "second section" described in the appended claims). The low-temperature areas 11B and 11C have a lower temperature than the high-temperature area 11A while the semiconductor chip 11 operates. The semiconductor chip 11 may be, for example, a die that is called a SoC (System on a chip). For example, the semiconductor chip 11 may include a processor core and a memory core. For example, then, the area of a circuit block where the processor core is formed may act as the high-temperature area 11A, and the areas of circuit blocks where the memory core is formed may act as the low-temperature areas 11B and 11C.

In the semiconductor package 310, the information regarding the semiconductor package 10 may be recorded in the low-temperature areas 11B and 11C. More specifically, the letter images A1 to A4 and the code B may be written, for example, by lasering, inking, or sealing. Further, the thermally conductive material 31 may be disposed on the upper surface 11a of the semiconductor chip 11. Letters, symbols, logos, marks, and codes are not written in the high-temperature area 11A of the upper surface 11a of the semiconductor chip 11. In such a case, the thermally conductive material 31 having fluidity becomes uneven on the upper surface 11a of the semiconductor chip 11. For example, an area where letter image A1 is written and an area of the code B may be provided with a smaller amount of thermally conductive material 31 than the other areas. However, the amount of heat generated in the low-temperature areas 11B and 11C is smaller than that in the high-temperature area 11A. Therefore, even when the amount of thermally conductive material 31 in the low-temperature areas 11B and 11C becomes small, the semiconductor chip 11 is able to maintain high cooling performance.

It should be noted that the above-described low-temperature areas 11B and 11C may be provided along the outer circumferential edge of the semiconductor chip 11. More specifically, when there is an area where no circuit block exists at the outer circumferential edge of the semiconductor chip 11 (semiconductor die), the information regarding the semiconductor package 10 may be written in that area.

The semiconductor package 310 depicted in FIG. 8 may be applied to the structures depicted in FIGS. 2, 5, and 6. More specifically, the insulation 15 (see FIGS. 2 and 5) and the sheets 215 and 225 may be attached to the semiconductor package 310. Further, the sealing member 33 may be disposed between the semiconductor package 310 and the radiator 50.

An example of the method of manufacturing the electronic device including the semiconductor package 310 will now be described.

First of all, the semiconductor package 310 is prepared. The semiconductor package 310 includes the semiconductor chip 11 and the package base material 17 on which the semiconductor chip 11 is to be mounted. As mentioned earlier, the capacitors 16 and other parts may be mounted on the package base material 17. Further, the stiffener 14 is mounted on the package base material 17, and the earlier-described insulation 15 is formed on the package base material 17. Instead of the insulation 15, the sheets 215 and 225 (FIG. 6) may be attached to the package base material 17. Furthermore, in the semiconductor package 310, the stiffener 14 need not be attached to the package base material 17. Next, the information regarding the semiconductor package 10 (e.g., the above-mentioned specific information) is written in the low-temperature areas 11B and 11C of the upper surface 11a of the semiconductor chip 11. For example, the information regarding the semiconductor package 10 is written in the low-temperature areas 11B and 11C by lasering, inking, sealing, or engraving.

The semiconductor package 310 is then mounted on the main substrate 2 by using the BGA 19. The thermally conductive material 31 having fluidity is disposed on the upper surface 11a of the semiconductor chip 11. In this instance, it is preferable that the thermally conductive material 31 be widely spread over the upper surface 11a of the semiconductor chip 11. Further, the sealing member 33 which surrounds the semiconductor chip 11 is attached to the semiconductor package 10 or the radiator 50. Finally, the radiator 50 is disposed on the upper surface 11a of the semiconductor chip 11 and thermally connected to the semiconductor chip 11. It should be noted that, before the radiator 50 is disposed on the upper surface 11a of the semiconductor chip 11, the thermally conductive material 31 may also be coated on the lower surface 50c of the radiator 50. One example of the method of manufacturing the electronic device including the semiconductor package 310 has been described above.

### [Example of Flattening by Surface Treatment Layer]

FIG. 9 is a cross-sectional view illustrating a semiconductor package 410 as a yet additional example of the semiconductor package. In FIG. 9, elements identical with those explained above are designated by the same reference numerals as the corresponding elements. The following mainly describes the difference from the semiconductor package described thus far. The examples described thus far may be applied to matters not covered by the description of the semiconductor package 410.

The semiconductor package 410 includes the semiconductor chip 11. The letter images A1 to A4 and/or the code B indicating the information regarding the semiconductor package 10 are written on the upper surface 11a of the semiconductor chip 11. In the example depicted in FIG. 9, the letter images A1 to A4 and/or the code B are written by lasering, and the upper surface 11a of an area where they are written is slightly recessed. A surface treatment layer 419 is formed on the upper surface 11a of the semiconductor chip 11. The surface treatment layer 419 covers the area where the above-mentioned letter images A1 to A4 and/or the code B are written. The surface treatment layer 419 may be formed all over the upper surface 11a of the semiconductor chip 11. The surface treatment layer 419 is provided on the upper surface 11a of the semiconductor chip 11 in order to resolve a wettability difference created on the upper surface 11a. The surface treatment layer 419 may make the flatness of the upper surface 11a uniform. The surface treatment layer 419 may be formed, for example, by a coating agent or grease. In the example depicted in FIG. 9, the area (recess section) where the letter images A1 to A4 and/or the code B are written is buried by the surface treatment layer 419 having an upper surface that is flat and has uniform wettability. The thermally conductive material 31 which has been described thus far is disposed between the surface treatment layer 419 and the radiator 50. In the above-described structure, the wettability of the thermally conductive material 31 having fluidity is also uniform and able to reduce thickness unevenness of the thermally conductive material 31. The upper surface of the surface treatment layer 419 need not necessarily be flat.

It should be noted that, in the semiconductor package 410, the information regarding the semiconductor package 10 (the letter images A1 to A4 and/or the code B) may be written by inking, sealing, or engraving instead of lasering. In such a case, the thickness of the surface treatment layer 419 may be decreased in an inked or a sealed area, and relatively increased in the other areas. Adopting the above-described configuration enables the surface treatment layer 419 to have a flat supper surface.

It is preferable that the surface treatment layer 419 be thinner than the thermally conductive material 31. When the surface treatment layer 419 is thinner than the thermally conductive material 31, the thermal resistance of the surface treatment layer 419 can be reduced. The thickness of the surface treatment layer 419 may be smaller than half the thickness of the thermally conductive material 31.

In the semiconductor package 410, the letter images A1 to A4 and the code B indicating the information regarding the semiconductor package 10 may be written in the low-temperature areas 11B and 11C, which have been described with reference to FIG. 8. Adopting the above-described configuration more effectively maintains high cooling performance of the semiconductor chip 11.

The semiconductor package 410 depicted in FIG. 9 may be applied to the structure depicted in FIGS. 2, 5, and 6. More specifically, the insulation 15 (see FIGS. 2 and 5) may be formed on the semiconductor package 410, and the sheets 215 and 225 may be attached to the semiconductor package 410. Further, the sealing member 33 may be disposed between the semiconductor package 410 and the radiator 50.

An example of the method of manufacturing the electronic device including the semiconductor package 410 will now be described.

First of all, the semiconductor package 410 is prepared. The semiconductor package 410 includes the semiconductor chip 11 and the package base material 17 on which the semiconductor chip 11 is to be mounted. As mentioned earlier, the capacitors 16 and other parts may be mounted on the package base material 17. Further, the stiffener 14 is mounted on the package base material 17, and the earlier-described insulation 15 is formed on the package base material 17. Instead of the insulation 15, the sheets 215 and 225 (FIG. 6) may be attached to the package base material 17. Furthermore, in the semiconductor package 410, the stiffener 14 need not be attached to the package base material 17. Next, the information regarding the semiconductor package 10 (e.g., the above-mentioned specific information) is written on the upper surface 11a of the semiconductor chip 11. For example, the information regarding the semiconductor package 10 is written on the upper surface 11a of the semiconductor chip 11 by lasering, inking, or sealing.

The semiconductor package 410 is then mounted on the main substrate 2 (see FIG. 2) by using the BGA 19. Further, the surface treatment layer 419 is formed on the upper surface 11a of the semiconductor chip 11 by coating grease on or applying a coating agent to the upper surface 11a. In this instance, the area where the information regarding the semiconductor package 10 is written is covered with the surface treatment layer 419. Next, the thermally conductive material 31 is disposed on the surface treatment layer 419. In this instance, it is preferable that the thermally conductive material 31 be spread all over the upper surface 11a of the semiconductor chip 11. Further, the sealing member 33 which surrounds the semiconductor chip 11 is attached to the semiconductor package 10 or the radiator 50. Finally, the radiator 50 is disposed on the upper surface 11a of the semiconductor chip 11 and thermally connected to the semiconductor chip 11. Before the radiator 50 is disposed on the upper surface 11a of the semiconductor chip 11, the thermally conductive material 31 may also be coated on the lower surface 50c of the radiator 50. One example of the method of manufacturing the electronic device including the semiconductor package 410 has been described above.

### [Conclusion]

The electronic device including the semiconductor package 10 depicted in FIGS. 1, 3, 4, and 7 is configured such that the information regarding the semiconductor package 10 is not written on the surface (upper surface 11a) of the semiconductor chip 11, but is written on a section that is positioned outside the outer edge 11d of the semiconductor chip 11 and inside the outer edge 17d of the package base material 17 (the stiffener 14, the surface (more specifically, the upper surface 17a) of the package base material 17, or another electronic part 12). Further, the thermally conductive material 31 having fluidity is disposed between the upper surface 11a of the semiconductor chip 11 and the radiator 50. This configuration maintains the flatness of the upper surface 11a of the semiconductor chip 11 and evenly spreads the thermally conductive material having fluidity over the upper surface 11a of the semiconductor chip 11. Therefore, the semiconductor chip 11 provides high cooling performance.

The electronic device including the semiconductor package 310 depicted in FIG. 8 is configured such that the surface of the semiconductor chip 11 has the high-temperature area 11A and the low-temperature areas 11B and 11C. The temperatures of the low-temperature areas 11B and 11C are lower than that of the high-temperature area 11A during an operation of the semiconductor chip 11. The information regarding the semiconductor package 10 is not written in the high-temperature area 11A of the semiconductor chip 11, but is written in the low-temperature areas 11B and 11C. The thermally conductive material 31 having fluidity is disposed between the upper surface 11a of the semiconductor chip 11 and the radiator 50. The low-temperature areas 11B and 11C generate a smaller amount of heat than the high-temperature area 11A. Therefore, even when the amount of thermally conductive material 31 in the low-temperature areas 11B and 11C is reduced, the semiconductor chip 11 is able to maintain high cooling performance.

The electronic device including the semiconductor package 410 depicted in FIG. 9 is configured such that the upper surface 11a of the semiconductor chip 11 has an area where the information regarding the semiconductor package 10 is written. The surface treatment layer 419 is formed on the upper surface 11a of the semiconductor chip 11 in order to cover the area where the information is written, and the thermally conductive material 31 having fluidity is disposed between the surface treatment layer 419 and the radiator 50. When this configuration is adopted, the surface treatment layer 419 forms a flat surface. Therefore, the thermally conductive material 31 can be evenly disposed between the surface treatment layer 419 and the radiator 50.

### [Modifications]

The electronic device, the semiconductor package, and the electronic device manufacturing method proposed by the present disclosure are not limited to the examples explained thus far, and may be variously modified.

The structures proposed by the present disclosure may be applied, for example, to a semiconductor package including a plurality of stacked semiconductor chips (silicon dies). Even in such a case, structures (1) to (3), which are described below, may be adopted.
(1) The information regarding the semiconductor chips may be written on an outer section (part) of the outer edge of the upper surface of a top semiconductor chip instead of being written on the upper surface of the top semiconductor chip.
(2) High- and low-temperature areas of the upper surface of the top semiconductor chip may be identified to write the information regarding the semiconductor chips in the low-temperature area.
(3) An area where the information regarding the semiconductor chips is written may be secured on the upper surface of the top semiconductor chip and covered with the surface treatment layer. Further, the thermally conductive material having fluidity may be disposed above the surface treatment layer.

## Claims

1. An electronic device comprising:
a semiconductor package that includes a semiconductor chip, a package base material, and a section positioned outside an outer edge of the semiconductor chip and inside an outer edge of the package base material, a package base material on which the semiconductor chip is mounted; and
a radiator, wherein
a thermally conductive material having fluidity is disposed between a surface of the semiconductor chip and the radiator, and
information regarding the semiconductor package is written on the section of the semiconductor package and not on the surface of the semiconductor chip.

2. The electronic device according to claim 1, wherein a part mounted on the package base material serves as the section where the information regarding the semiconductor package is written.

3. The electronic device according to claim 2, wherein the semiconductor package includes a stiffener as the section where the information regarding the semiconductor package is written, the stiffener being mounted on the package base material.

4. The electronic device according to claim 2, wherein the semiconductor package includes an electronic part as the section where the information regarding the semiconductor package is written, the electronic part being mounted on the package base material and configured to generate a smaller amount of heat than the semiconductor chip.

5. The electronic device according to claim 1, wherein a part of the package base material serves as the section where the information regarding the semiconductor package is written.

6. The electronic device according to claim 1, wherein at least one of a letter, a symbol, and a code indicating the information regarding the semiconductor package is written on the section by at least one of inking, lasering, and sealing.

7. The electronic device according to claim 1, wherein a liquid metal serves as the thermally conductive material.

8. The electronic device according to claim 1, further comprising:
a sealing member that surrounds the semiconductor chip,
wherein
the section where the information regarding the semiconductor package is written is positioned outside the sealing member.

9. The electronic device according to claim 1, wherein the section where the information regarding the semiconductor package is written is covered with a removable member.

10. An electronic device comprising:
a semiconductor package that includes a semiconductor chip and
a package base material on which the semiconductor chip is mounted; and
a radiator, wherein
the semiconductor package includes a first section and a second section, the first section being configured to transfer heat from the semiconductor chip to the radiator through a thermally conductive material having fluidity, the thermally conductive material being formed on the first section, the second section being different from the first section, and information regarding the semiconductor package is written on the second section.

11. The electronic device according to claim 10, wherein the thermally conductive material is not attached to the second section.

12. An electronic device comprising:
a semiconductor package that includes a semiconductor chip and
a package base material on which the semiconductor chip is mounted; and
a radiator, wherein
a thermally conductive material having fluidity is disposed between a surface of the semiconductor chip and the radiator,
the surface of the semiconductor chip has a first area and a second area, the second area having a lower temperature than the first area during an operation of the semiconductor chip, and
information regarding the semiconductor package is written in the second area of the semiconductor chip and not in the first area.

13. The semiconductor package according to claim 12, wherein the second area is provided along an outer edge of the surface of the semiconductor chip.

14. An electronic device comprising:
a semiconductor package that includes a semiconductor chip and a package base material on which the semiconductor chip is mounted; and
a radiator, wherein
a surface of the semiconductor chip has an area where information regarding the semiconductor package is written,
a surface treatment layer covering the area is formed on the surface of the semiconductor chip, and
a thermally conductive material having fluidity is disposed between the surface treatment layer and the radiator.

15. The electronic device according to claim 14, wherein the surface treatment layer is thinner than the thermally conductive material.

16. A semiconductor package comprising:
a semiconductor chip;
a package base material on which the semiconductor chip is mounted; and
a section positioned outside an outer edge of the semiconductor chip and inside an outer edge of the package base material, wherein
information regarding the semiconductor package is written on the section of the semiconductor package and not on the surface of the semiconductor chip.

17. A semiconductor package comprising:
a semiconductor chip; and
a package base material on which the semiconductor chip is mounted, wherein
a surface of the semiconductor chip has a first area and a second area, the second area having a lower temperature than the first area during an operation of the semiconductor chip, and
information regarding the semiconductor package is written in the second area of the semiconductor chip and not in the first area.

18. An electronic device manufacturing method comprising:
a step of preparing a semiconductor package including a semiconductor chip, a package base material, and a section positioned outside an outer edge of the semiconductor chip and inside the outer edge of the package base material, the semiconductor chip being mounted on the package base material;
a step of writing information regarding the semiconductor package on the section of the semiconductor package and not on a surface of the semiconductor chip; and
a step of disposing a thermally conductive material having fluidity on the surface of the semiconductor chip.

19. An electronic device manufacturing method comprising:
a step of preparing a semiconductor package including a semiconductor chip and a package base material, a surface of the semiconductor chip having a first area and a second area,
the semiconductor chip being mounted on the package base material, the second area having a lower temperature than the first area during an operation of the semiconductor chip;
a step of writing information regarding the semiconductor package in the second area of the semiconductor chip and not in the first area; and
a step of disposing a thermally conductive material having fluidity on the surface of the semiconductor chip.

20. An electronic device manufacturing method comprising:
a step of preparing a semiconductor package including a semiconductor chip and a package base material on which the semiconductor chip is mounted, an area where information regarding the semiconductor package is written being secured on a surface of the semiconductor chip;
a step of forming a surface treatment layer covering the area on the surface of the semiconductor chip; and
a step of disposing a thermally conductive material having fluidity on the surface treatment layer.
